Europäisches Patentamt

European Patent Office

Office européen des brevets

(19)

(11) Veröffentlichungsnummer : **0 458 077 B1**

(12) **EUROPÄISCHE PATENTSCHRIFT**

(45) Veröffentlichungstag der Patentschrift :
**24.11.93 Patentblatt 93/47**

(51) Int. Cl.$^5$ : **C30B 23/02, C30B 23/06**

(21) Anmeldenummer : **91106630.6**

(22) Anmeldetag : **24.04.91**

(54) **Verfahren zum Eichen oder Nacheichen einer Strahldruck-Messeinrichtung einer Molekularstrahlexpitaxieeinrichtung und Vorrichtung zur Durchführung des Verfahrens.**

(30) Priorität : **16.05.90 DE 4015787**
**15.10.90 DE 4032729**

(43) Veröffentlichungstag der Anmeldung :
**27.11.91 Patentblatt 91/48**

(45) Bekanntmachung des Hinweises auf die
Patenterteilung :
**24.11.93 Patentblatt 93/47**

(84) Benannte Vertragsstaaten :
**DE FR GB**

(56) Entgegenhaltungen :
**DE-A- 3 715 717**
**FR-A- 2 583 071**

(56) Entgegenhaltungen :
**JOURNAL OF VACUUM SCIENCE & TECHNO-
LOGY B, Band 3, Nr. 4, Juli-August 1985, Seiten 964-967, New York, US; R. WUNDER et al.:
"Automated growth of AlxGa1-xAs and In-
xGa1-xAs by molecular beam epitaxy using an
ion gauge flux monitor"
PATENT ABSTRACTS OF JAPAN, Band 9, Nr.
91 (C-277)[1814], 19. April 1985; & JP-A-59 223
293**

(73) Patentinhaber : **SIEMENS
AKTIENGESELLSCHAFT
Wittelsbacherplatz 2
D-80333 München (DE)**

(72) Erfinder : **Heinecke, Harald, Dr.
Egmatinger Strasse 13c
W-8011 Dürnhaar (DE)**

## Beschreibung

Die Erfindung betrifft ein Verfahren zum Eichen oder Nacheichen einer Strahldruck-Meßeinrichtung nach dem Oberbegriff des Patentanspruchs 1.

Bei Festquellen-Molekularstrahlepitaxie von Halbleitermaterialien wird mittels einer Meßeinrichtung, z.B. in Form einer Ionisationsmeßröhre, der Strahldruck der kristallkonstituierenden Elemente gemessen (siehe journal of Vacuum Science and Technology B, Bd.3, No.4, Juli-August 1985, S. 964-967, New York; JP-A-59-223 293, oder FR-A-2 583 071). Es werden sog. Eichkurven erstellt, bei denen Strahldrucke über den Temperaturen der z.B. als Effusionszellen ausgebildeten Festquellen aufgetragen sind. Dabei tritt das Problem auf, daß sich wichtige Kenngrößen wie Sensitivität und Charakteristik einer Ionisationsmeßröhre im Laufe der Zeit ändern. Dies gilt insbesondere, wenn die Hochvakuumkammer wegen Wartungs- oder Zellennachfüllarbeiten geflutet werden muß. Als Folge ergeben sich dann trotz gleicher gemessener Strahldruckwerte unterschiedliche Materialflüsse zur Wachstumsoberfläche. Dieser Effekt schränkt die Reproduzierbarkeit bezüglich Schichtdicke sowie Materialzusammensetzung der gewachsenen Halbleiterschichten deutlich ein. Dies muß in Produktionsnähe vermieden werden.

Eine Lösung des Problems besteht darin, häufiger spezielle Teststrukturen zu wachsen und diese bezüglich Schichtdicken und Materialzusammensetzung auszuwerten. Mit Hilfe der Analysedaten kann durch Zurückrechnen festgestellt werden, ob oder inwieweit sich die Kenngrößen der Ionisationsmeßröhre verändert haben. Diese Methode ist aufwendig und für eine in Produktionsnähe zu erzielende hohe Ausbeute ungünstig. Überdies sind Charakteristikänderungen der Effusionszellen nicht trennbar. Bei Folgeexperimenten können lediglich gemittelte Ed/Sti - 12.10.1990 Korrekturwerte angenommen werden.

Aufgabe der Erfindung ist es, aufzuzeigen, wie auf einfache Weise bei der Molekularstrahlepitaxie die Genauigkeit im Hinblick auf die zu erzielenden Schichtdicken und/oder Materialzusammensetzungen verbessert und die Ausbeute in einer der Produktionsnähe genügenden Weise erhöht werden kann.

Diese Aufgabe wird durch ein Verfahren der eingangs genannten Art gelöst, welches die im kennzeichnenden Teil des Patentanspruchs 1 angegebenen Merkmale aufweist.

Die Erfindung beruht darauf, daß der Strahldruck des eingestrahlten Gases eine umkehrbar eindeutige Funktion der Druckdifferenz zwischen dem vorbestimmten größeren Druck und dem Hochvakuumdruck in der evakuierten Hochvakuumkammer ist. Bei genauer Einstellung dieser Drucke läßt sich vermöge dieser bekannten Funktion der Strahldruck des eingestrahlten Gases entsprechend genau und reproduzierbar festlegen, wobei der Strahldruck um so genauer bestimmt werden kann, je genauer die Druckdifferenz eingestellt wird.

Es ist dabei von Vorteil, wenn der vorbestimmte Druck im Vergleich zum Vakuumdruck nach Maßgabe des Anspruchs 2 eingestellt wird. Dabei gilt: Je größer der vorbestimmte Druck im Vergleich zum Hochvakkumdruck gewählt wird, desto mehr kann der Hochvakuumdruck vernachlässigt werden und hängt der Strahldruck praktisch allein von dem vorbestimmten Druck ab. In der Praxis ist der Hochvakuumdruck in der Regel kleiner als $10^{-5}$ Torr oder $10^{-3}$Pa. Nicht zuletzt in diesem Fall hat sich ein größerer Druck von 0,1 bis 1 Torr oder von 10 bis $10^5$ Pa (Anspruch 3) als günstig erwiesen.

Vorteilhaft bei dem erfindungsgemäßen Verfahren ist, daß ein relativer Druckstandard eingeführt werden kann, mit dessen Hilfe sich die Kenngrößen des verwendeten Meßgeräts zum Messen des Strahldrucks, insbesondere einer Ionisationsmeßröhre in direkter Weise jederzeit neu bestimmen lassen.

Weitere besonders vorteilhafte Ausgestaltungen des erfindungsgemäßen Verfahrens, die sich für eine softwaremäßige automatische und regelmäßige Nacheichung der Meßeinrichtung und/oder ganzen Molekularstrahlepitaxieeinrichtung eignen und mit denen bequem, beispielsweise alterungsbedingte und kenngrößenverfälschende, Veränderungen dieser Einrichtungen berücksichtigt werden können, sind in den Ansprüchen 4 bis 7 angegeben.

Eine erfindungsgemäße Eichvorrichtung zur Durchführung des erfindungsgemäßen Verfahrens geht aus dem Anspruch 8 hervor.

Das erfindungsgemäße Verfahren und die erfindungsgemäße Vorrichtung sind sowohl für Gasquellen- als auch Festquellen-Molekularstrahlepitaxieeinrichtungen geeignet. Bei Gasquellenepitaxie mit beispielsweise mehreren Gasquellen genügt es, wenn nur bezüglich einer Gasquelle die Merkmale des Anspruchs 4 realisiert werden. Die Meßeinrichtung zum Messen des Strahldrucks wird bezüglich dieser Gasquelle geeicht, und der von dieser Gasquelle erzeugte Strahldruck bildet den relativen Druckstandard für die Strahldrucke der von den übrigen Gas- oder auch Festquellen erzeugten Atom- oder Molekularstrahlen.

Besonders bevorzugt und vorteilhaft ist das erfindungsgemäße Verfahren bei Festquellen-Molekularstrahlepitaxie anwendbar. Eine Festquellen-Molekularstrahlepitaxieeinrichtung, bei der die Erfindung angewendet ist, unterscheidet sich von einer herkömmlichen Festquellen-Molekularstrahlepitaxieeinrichtung durch die Merkmale des Anspruchs 4, d.h. eine erfindungsgemäße Festquellen-Einrichtung weist im wesentlichen zusätzlich eine Gasquelle und eine Gasinjektionseinrichtung auf, die im vorbestimmten Druck genau, möglichst hochpräzise einstellbar sind.

Die Erfindung wird in der folgenden Beschreibung anhand der Figur beispielhaft näher erläutert. Es zeigen:

Figur 1      in schematischer Darstellung die wesentlichen Teile einer Molekularstrahlepitaxieeinrichtung, soweit sie zur Erläuterung der Erfindung erforderlich sind, und

Figur 2      ein Diagramm, in dem Meßwerte und Meßwertkurven über dem größeren Druck $p_v$ aufgetragen sind.

In der Figur ist mit 1 eine Hochvakuumkammer einer Molekularstrahlepitaxieeinrichtung bezeichnet, an die eine hochpräzise Gasinjektionslinie 2 angebaut ist, mit der ein Gasstrahl 3 auf einen Punkt 4 im inneren der Hochvakuumkammer 1 eingestrahlt werden kann. In dem Punkt 4 kann wahlweise ein Substrat, auf das Schichten epitaktisch aufgewachsen werden sollen, oder ein Meßgerät 5 zum Messen des Strahldrucks $P_{st}$ eines oder oder mehrerer auf den Punkt 4 gerichteter Atom- oder Molekularstrahlen 6, 7durch einen geeigneten Umstellmechanismus angeordnet werden, ohne daß der Hochvakuumdruck in der Hochvakuumkammer 1 beeinträchtigt wird. Bei Gasquellen-Molekularstrahlepitaxie werden die kristallkonstituierenden Atom- oder Molekularstrahlen 6 von in der Regel mehreren Gasquellen 60 erzeugt, die mit nicht dargestellten Öffnungen in der Hochvakuumkammer 1 verbunden sind. Bei Festquellenepitaxie werden die kristallkonstituierenden Atom- oder Molekularstrahlen 7 von in der Regel mehreren Festquellen 70, beispielsweise Effusionszellen, erzeugt, die an der Hochvakuumkammer 1 angeordnet sind.

Die Gasinjektionslinie 2 weist eine in das Innere der Hochvakuumkammer 1 führende Injektionskapillare 20 als Gasleitung auf, die mit einem Gasbehälter 21 verbunden ist, der ein vorgebbares Gas enthält und die Gasquelle bildet. In der Injektionskapillare 20 sind ein Regelventil 22 und ein beispielsweise aus einer Edelstahlscheibe bestehendes Flußelement 23 mit einer Öffnung 231 konstanten Durchmessers angeordnet. Zwischen dem Regelventil 22 und dem näher an der Vakuumkammer 1 angeordneten Flußelement 23 ist ein kapazitiver Präzisionsdruckaufnehmer 24 an die Injektionskapillare 20 angeschlossen, der den Druck in der Kapillare 20 zwischen dem Regelventil 22 und dem Flußelement 23 hochpräzise aufnimmt und den aufgenommenen Druck dem Regelventil 22 als Istwert zuführt. Dadurch kann der Druck $P_v$ in der Kapillare 20 zwischen dem Regelventil 22 und dem Flußelement 23 hochpräzise voreingestellt und gehalten werden. Dadurch ist ein präzise gesteuerter Druckabfall entlang dem Flußelement 23 gegeben, über den der in die Hochvakuumkammer 1 strömende Massenfluß und damit der Strahldruck $P_{st}$ in der Molekularstrahlepitaxieeinrichtung präzise gesteuert werden. Auf diese Weise können verschiedene Strahldrucke eingestellt und zu beliebigen Zeitpunkten mit hoher Genauigkeit reproduziert werden.

Darüberhinaus können auch Änderungen bezüglich der Effusionszellencharakteristik mit einem in der hier beschriebenen Art geeichten Meßgerät 5 eindeutiger untersucht werden.

Als für die Eichung geeignete Gase können je nach Anwendung oder Anforderung verschiedene Gase eingesetzt werden, beispielsweise $N_2$, $H_2$, Ar, $CH_4$ usw..

Bei einem konkreten Ausführungsbeispiel wurde als kapazitiver Druckaufnehmer 24 ein Aufnehmer des Typs 390 der Firma MKS und als Regelventil 22 mit Elektronik ein Ventil des Typs 244/245 der gleichen Firma MKS verwendet. Die Injektionskapillare 20 führte in die Hochvakuumkammer 1 einer Gasquellen-Molekularstrahleinrichtung, in der ein Hochvakuumdruck von weniger als $10^{-5}$ Torr oder $10^{-3}$ Pa aufrechterhalten wurde. Der vorbestimmte Druck $P_v$ wurde auf einen Wert zwischen 0,1 und 1 Torr oder 10 und 150 Pa hochpräzise eingestellt. Der Durchmesser der Öffnung 231 des Flußelements 23 betrug 0,6 mm. Durch diesen Durchmesser ist sichergestellt, daß der Massenfluß in die Hochvakuumkammer 1 nicht so groß ist, daß der Hochvakuumdruck in dieser Kammer 1 beeinträchtigt wird.

Für den Strahldruck $P_{st}$ gilt

$$P_{st} = f(P_v - P_{hv})$$

wobei f eine bekannte Funktion und $P_{hv}$ den Hochvakuumdruck in der Kammer 1 bedeuten.

Die Bezugszeichen 25 und 26 in der Figur bezeichnen Absperrventile, von denen eines in einem Evakuierungsanschluß 27 angeordnet ist.

Bei dem Ausführungsbeispiel ist der Hochvakuumdruck $P_{hv}$ kleiner als $10^{-5}$ Torr oder $10^{-3}$ Pa und damit vernachlässigbar klein gegenüber $P_v$, so daß der Strahldruck $P_{st}$ als Funktion der Druckes $P_v$ allein betrachtet werden kann.

Mit Hilfe des bei dem Ausführungsbeispiel durchgeführten erfindungsgemäßen Referenz-Eichverfahrens konnte auf Anhieb aus einer neueingebauten Quelle eine GaInAs-Schicht mit einer Fehlanpassung bezüglich InP von weniger als $4 \times 10^{-4}$ hergestellt werden. Dies bedeutet eine Eichgenauigkeit von deutlich besser als 0,5 % vom Auslesewert.

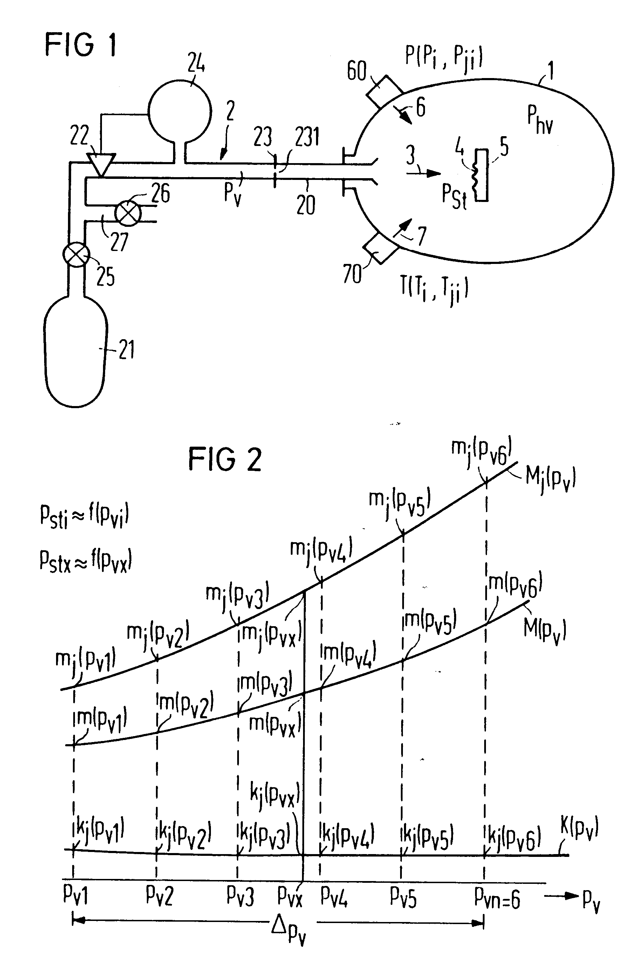

Um kenngrößenverfälschende Veränderungen der Meßeinrichtung und/oder der ganzen Molekularstrahlepitaxieeinrichtung bequem automatisch und softwaremäßig berücksichtigen zu können, wird in dem Fall, daß für die Atom- oder Molekularstrahlen 6 oder 7 n(n = 1, 2, 3, ...) diskrete Strahldruckwerte $p_{sti}$ mit i = 1, 2, ..., n ausgewählt oder vorgegeben sind, erfindungsgemäß unter Bezugnahme auf Figur 2 wie folgt vorgegangen:

Die Meßeinrichtung 5 wird auf diese diskreten Strahldruckwerte $p_{sti}$ eingemessen, indem für jeden dieser Druckwerte $p_{sti}$ das vorgebbare Gas in der Gasinjektionslinie 2 auf den zu diesem Strahldruckwert $p_{sti}$ durch $p_{sti} = f(p_{vi} - p_{hv})$ korrespondierenden Druckwert $p_{vi}$ des höheren Druckes $p_v$ voreingestellt, die Meßeinrichtung 5 mit dem auf diesen Druckwert $p_{vi}$ eingestellten Gas beaufschlagt und der von der Meßeinrichtung 5 bei diesem Druckwert $p_{vi}$ gelieferten Meßwert $m(p_{vi})$ als ursprünglicher Meßwert aufgenommen wird. Es wird auf diese Weise für jeden der n Druckwerte $p_{vi}$ ein zugeordneter ursprünglicher Meßwert $m(p_{vi})$ erhalten, der beispielsweise in einem Speicher abgespeichert werden kann, wobei der zugehörige diskrete Druckwert $p_{vi}$ als Adresse verwendet werden kann. In der Figur 2 ist beispielhaft ohne Beschränkung der Allgemeinheit n = 6 angenommen.

Soll ein Atom- oder Molekularstrahl 6 oder 7 einer beliebigen Gasquelle oder Festquelle 70 auf einen der n diskreten Strahldruckwerte, beispielsweise den Strahldruckwert $p_{sti}$, eingestellt werden, wird die Meßeinrichtung 5 mit diesem Strahl 6 oder 7 beaufschlagt und ein den Strahldruck dieses Strahls 6 oder 7 beeinflussender Betriebsparameter dieser Quelle 60 oder 70 - bei einer Gasquelle 60 in der Regel ein Gasquellendruck P und bei einer Festquelle 70 in der Regel eine Festquellentemperatur T - auf einen Parameterwert $P_i$ oder $T_i$ eingestellt, bei dem die Meßeinrichtung 5 den ursprünglichen Meßwert $m(p_{vi})$ anzeigt, der bei dem zu diesem Strahldruckwert $p_{sti}$ korrespondierenden Druckwert $P_{vi}$ des höheren Druckes $p_v$ abgespeichert ist. Zeigt die Meßeinrichtung 5 diesen Meßwert $m(p_{vi})$ an, ist der betreffende Strahl 6 oder 7 auf diesen Strahldruckwert $p_{sti}$ eingestellt und dieser Strahl 6 oder 7 kann mit diesem Strahldruckwert $p_{sti}$ ein betreffendes Substrat beaufschlagen.

Um kenngrößenverfälschende Änderungen zu berücksichtigen, wird die Meßeinrichtung 5 von Zeit zu Zeit, d.h. wenigstens einmal, in der Regel immer wieder, für die n diskreten Strahldruckwerte $p_{sti}$ nacheingemessen, indem bei jeder Nacheinmessung j (j = 1, 2, ...) erneut für jeden dieser Strahldruckwerte $p_{sti}$ die Meßeinrichtung 5 mit dem genau auf den zu diesem Strahldruckwert $p_{sti}$ korrespondierenden Druckwert $p_{vi}$ des höheren Druckes $p_v$ eingestellten vorgebbaren Gas beaufschlagt und der von der Meßeinrichtung bei diesem Druck $p_{vi}$ gelieferte diskrete Meßwert $m_j(p_{vi})$ neu aufgenommen wird. Auch dieser neu aufgenommene Meßwert $m_j(p_{vi})$ kann bei diesem Druckwert $p_{vi}$ in einem Speicher abgespeichert werden.

Hat sich das Meßgerät 5 verändert, stimmen der ursprüngliche Meßwert $m(p_{vi})$ und der neu aufgenommene Meßwert $m_j(p_{vi})$, die bei diesem Druckwert $p_{vi}$ des höheren Druckes $p_v$ abgespeichert sind, nicht überein. Soll in diesem Fall ein Atom- oder Molekularstrahl 6 oder 7 einer beliebigen Quelle 60 oder 70 auf einen der n diskreten Strahldruckwerte, beispielsweise den Strahldruck $p_{sti}$, eingestellt werden, wird die Meßeinrichtung 5 mit diesem Strahl 6 oder 7 beaufschlagt. Zeigt die Meßeinrichtung 5 nicht schon den neuen Meßwert $m_j(p_{vi})$ an, der bei dem zu diesem Strahldruckwert $p_{sti}$ korrespondierenden Druckwert $p_{vi}$ des höheren Druckes $p_v$ abgespeichert ist, wird der Betriebsparameter P oder T der betreffenden Quelle 60 oder 70 auf einen Parameterwert $P_{ji}$ oder $T_{ji}$ eingestellt, bei dem die Meßeinrichtung 5 diesen neuen Meßwert $m_j(p_{vi})$ anzeigt. Zeigt die Meßeinrichtung 5 diesen neuen Meßwert $m_j(p_{vi})$ an, ist der betreffende Strahl 6 oder 7 auf diesen Strahldruckwert $p_{sti}$ eingestellt und dieser Strahl 6 oder 7 kann mit diesem Strahldruckwert $p_{sti}$ ein betreffendes Substrat beaufschlagen.

Für die softwaremäßige Automatisierung kann es vorteilhaft sein, aus den diskreten ursprünglichen Meßwerten $m(p_{vi})$ und den bei einer Nacheinmessung neu aufgenommenen diskreten Meßwerten $m_j(p_{vi})$ Korrekturfaktoren $k_j(p_{vi})$ zu bilden, indem für jeden diskreten Druckwert $p_{vi}$ des höheren Druckes $p_v$ der Quotient $m(p_{vi})/m_j(p_{vi})$ aus dem ursprünglichen Meßwert $m(p_{vi})$ und dem neuaufgenommenen Meßwert $m_j(p_{vi})$, die zu diesem Druckwert $(p_{vi})$ korrespondieren, gebildet und als der zu diesem Druckwert $p_{vi}$ korrespondierende Korrekturfaktor $k_j(p_{vi}) = m(p_{vi})/m_j(p_{vi})$ verwendet wird, der bei diesem Druckwert $p_{vi}$ in einem Speicher abgespeichert werden kann.

Hat sich das Meßgerät 5 verändert, ist bei wenigstens einem der n diskreten Druckwerte des höheren Druckes $p_v$, beispielsweise bei dem diskreten Druckwert $p_{vi}$, der dazu korrespondierende Korrekturfaktor $k_j(p_{vi})$ ungleich 1. Soll in diesem Fall der Strahldruck $p_{st}$ eines Atom- oder Molekularstrahls 6 oder 7 einer beliebigen Quelle 60 oder 70 auf den zu diesem diskreten Druckwert $p_{vi}$ korrespondierenden Strahldruckwert $p_{sti}$ eingestellt werden, wird die Meßeinrichtung 5 mit diesem Strahl 6 oder 7 beaufschlagt und der Betriebsparameter P oder T der betreffenden Quelle 60 oder 70 auf einen Parameterwert $P_{ji}$ oder $T_{ji}$ eingestellt, bei dem die Meßeinrichtung 5 einen Wert anzeigt, der gleich dem Quotienten $m(p_{vi})/k_j(p_{vi})$ aus dem ursprünglichen Meßwert $m(p_{vi})$ und dem Korrekturfaktor $k_j(p_{vi})$ ist. Dieser Wert ist gleich dem neuen Meßwert $m_j(p_{vi})$ und zeigt die Meßeinrichtung 5 diesen Wert an, ist der betreffende Strahl 6 oder 7 auf den zu diesem Druckwert $p_{vi}$ korrespondierenden Strahldruck $p_{sti}$ eingestellt und dieser Strahl 6 oder 7 kann mit diesem Strahldruck $p_{sti}$ ein betreffendes Substrat beaufschlagen.

Das vorstehend geschilderte und für eine softwaremäßige Automatisierung geeignete Verfahren kann für beliebige Druckwerte $p_{vx}$ aus einem Druckwertbereich $\Delta p_v$ des höheren Druckes $p_v$ und den zu solchen Druck-

werten $p_v$ korrespondierenden Strahldruckwerten $p_{stx}$ = $f(p_{vx} - p_{hv})$ wie folgt erweitert werden.

Es werden bei vorgebbaren diskreten Druckwerten $p_{vi}$ des höheren Druckes $p_v$ ursprüngliche diskrete Meßwerte $m(p_{vi})$ wie oben beschrieben aufgenommen. Durch ein vorgebbares Interpolations- und/oder Extrapolationsverfahren wird eine in einem vorbestimmten kontinuierlichen Druckwertbereich $\Delta p_v$ des höheren Druckes $p_v$ kontinuierlich von diesem Druck $p_v$ abhängige ursprüngliche Meßwertfunktion $M(p_v)$ erstellt. Jedem beliebigen Druckwert $p_{vx}$ aus dem Druckwertbereich $\Delta p_v$ ist aufgrund dieser ursprünglichen Meßwertfunktion $M(p_v)$ ein Funktionswert $m(p_{vx})$ zugeordnet, zu dem der Strahldruckwert $p_{stx}$ = $f(p_{vx} - p_{hv})$ korrespondiert.

Soll ein Atom- oder Molekularstrahl 6 oder 7 einer beliebigen Gasquelle 60 oder 70 auf einem solchen Strahldruckwert $p_{stx}$ eingestellt werden, wird die Meßeinrichtung 5 mit diesem Strahl 6 oder 7 beaufschlagt und der den Strahldruck dieses Strahls 6 oder 7 beeinflussende Betriebsparameter P oder T dieser Quelle 60 oder 70 auf einen Parameterwert $P_x$ oder $T_x$ eingestellt, bei dem die Meßeinrichtung 5 den Funktionswert $m(p_{vx})$ der ursprünglichen Meßwertfunktion $M(p_v)$ bei dem Druckwert $p_{vx}$ auf dem Druckwertbereich $\Delta p_v$ anzeigt, der zu diesem Strahldruckwert $p_{stx}$ korrespondiert. Zeigt die Meßeinrichtung 5 diesen Funktionswert $m (p_{vx})$ an, ist der betreffende Strahl 6 oder 7 auf diesen Strahldruckwert $p_{stx}$ eingestellt und dieser Strahl 6 oder 7 kann mit diesem Strahldruckwert $p_{stx}$ ein betreffendes Substrat beaufschlagen.

Um kenngrößenverfälschende Veränderungen zu berücksichtigen, wird die Meßeinrichtung von Zeit zu Zeit für die vorgebbaren diskreten Druckwerte $p_{vi}$ im obigen Sinne nacheingemessen, wobei bei jeder solchen Nacheinmessung j = 1, 2, 3 ... neuaufgenommene diskrete Meßwerte $m_j(p_{vi})$ erhalten werden. Auf diesen neuaufgenommenen diskreten Meßwerten $m_j (p_{vi})$ wird beispielsweise durch das genannte Interpolations- und/oder Extrapolationsverfahren eine in dem vorbestimmten Druckwertbereich $\Delta p_v$ des höheren Druckes $p_v$ kontinuierlich von diesem Druck $p_v$ abhängige neue Meßwertfunktion $M_j(p_v)$ erstellt,

Hat sich die Meßeinrichtung 5 verändert, stimmt die neu aufgenommene Meßwertfunktion $M_j(p_v)$ nicht mit der ursprünglichen Meßwertfunktion $M(p_v)$ überein, so daß für bestimmte Druckwerte $p_{vx}$ der zugeordnete Funktionswert $m_j(p_{vx})$ der neu aufgenommenen Meßwertfunktion $M_j(p_v)$ verschieden vom zugeordneten Funktionswert $m(p_{vx})$ der ursprünglichen Meßwertfunktion $M(p_v)$ ist.

Soll der Strahldruck $p_{st}$ eines Atom- oder Molekularstrahls 6 oder 7 einer beliebigen Quelle 60 oder 70 auf einen Strahldruckwert $p_{stx}$ eingestellt werden, der zu einem solchen Druckwert $p_{vx}$ korrespondiert, wird die Meßeinrichtung 5 mit diesem Strahl 6 oder 7 beaufschlagt und der den Strahldruck dieses Strahls 6 oder 7 beeinflussende Betriebsparameter P oder T dieser Quelle 60 oder 70 auf einen Parameterwert $P_{jx}$ oder $T_{jx}$ eingestellt, bei dem die Meßeinrichtung 5 den zu diesem Druckwert $p_{vx}$ gehörenden Funktionswert $m_j(p_{vx})$ der neuen Meßwertfunktion $M_j(P_v)$ anzeigt.

Es kann bei diesem erweiterten Verfahren auch so vorgegangen werden, daß bei einer Nacheinmessung der Meßeinrichtung 5 mit der bei dieser Nacheinmessung erstellten neuen Meßwertfunktion $M_j(p_v)$ und der ursprünglich erstellten Meßwertfunktion $M(p_v)$ und der ursprünglichen Meßwertfunktion $M(p_v)$ eine Korrekturfaktorfunktion $K(p_v)$ erstellt wird, bei der jedem Druckwert $p_{vx}$ aus dem Druckwertbereich $\Delta p_v$ ein Korrekturfunktionswert $k_j(p_{vx})$ zugeordnet ist, der dem Quotienten $m(p_{vx})/m_j(p_{vx})$ aus dem zu diesem Druckwert $p_{vx}$ gehörenden Funktionswert $m(p_{vx})$ der ursprünglichen Meßwertfunktion $M(p_v)$ und dem zu diesem Druckwert $(p_{vx})$ gehörenden Funktionswert $m_j(p_{vx})$ der neuen Meßwertfunktion $M_j(p_v)$ entspricht.

Das die Interpolation oder Extrapolation verwendende Verfahren ist für höchste Genauigkeitsansprüche geeignet. Für die Interpolation oder Extrapolation können Polynome verwendet werden, deren Grad sich nach der geforderten Genauigkeit bestimmt. Es können auch Stufenfunktionen verwendet werden, bei denen die Genauigkeit durch den Abstand der diskreten Druckwerte $p_{vi}$ des höheren Druckes $p_v$ beeinflußt werden kann. Bei der Erstellung einer neuen Meßwertfunktion $M_j(p_v)$ kann auch so vorgegangen werden, daß zuerst für die diskreten Druckwerte $p_{vi}$ Korrekturfaktoren $k_j(p_{vi})$ = $m(p_{vi})/m_j(p_{vi})$ errechnet werden und daraus durch das Interpolations- oder Extrapolationsverfahren eine Korrekturfaktorfunktion $K_j(p_v)$ erstellt wird. Die neue Meßwertfunktion ist dann implizite durch $M_j(p_v)$ = $M(p_v).K^{-1}(p_v)$ gegeben

Besonders einfach wird das Verfahren, wenn sich für alle diskreten Druckwerte $p_{vi}$ der gleiche Korrekturfaktor $k_j(p_{vi})$ = $k_j$ ergibt. In diesem Fall kann für jeden beliebigen Druckwert $p_{vx}$ aus dem Druckwertbereich $\Delta p_v$ der neue Mßwert $m_j(p_{vx})$ für diesen Druckwert $p_{vx}$ durch Division des ursprünglichen Wertes $m(p_{vx})$ bei diesem Druckwert $p_{vx}$ durch den Faktor $k_j$ erhalten werden.

Anstelle der obigen Korrekturfaktoren $k_j(p_{vi})$ oder $k_j(p_{vx})$, die durch Division des betreffenden ursprünglichen Meßwertes $m(p_{vi})$ oder $m(p_{vx})$ durch den betreffenden neuen Meßwert $m_j(p_{vi})$ oder $m_j(p_{vx})$ erhalten werden, können auch Korrekturfaktoren $k'_j(p_{vi})$ oder $k'_j(p_{vx})$ verwendet werden, die durch Division des betreffenden neuen Meßwertes $m_j(p_{vi})$ oder $m_j(p_{vx})$ durch den betreffenden ursprünglichen Meßwert $m(p_{vi})$ oder $m(p_{vx})$ gebildet werden. In diesem Fall ergibt sich für jeden beliebigen Druckwert $p_{vi}$ oder $p_{vx}$ der neue Meßwert $m_j(p_{vi})$ oder $m_j(p_{vx})$ nicht durch Division, sondern durch Multiplikation des betreffenden ursprünglichen Meßwertes $m(p_{vi})$ oder $m(p_{vx})$ mit dem betreffenden Korrekturfaktor $k'_j(p_{vi})$ oder $k'_j(p_{vx})$.

**Patentansprüche**

1. Verfahren zum Eichen oder Nacheichen einer in einer Hochvakuumkammer (1) einer Molekularstrahlepitaxieeinrichtung, insbesondere einer Festquellen-Molekularstrahlepitaxieeinrichtung angeordneten Meßeinrichtung (5) zum Messen des Strahldrucks ($P_{st}$) eines in die evakuierte Hochvakuumkammer (1) eingestrahlten kristallkonstituierenden Atom- oder Molekularstrahls (6; 7),
   **dadurch gekennzeichnet,**
   daß zum Eichen oder Nacheichen der Meßeinrichtung (5) ein vorgebbares Gas genau auf einen vorbestimmten, gegenüber dem in der evakuierten Hochvakuumkammer (1) herrschenden Hochvakuumdruck ($P_{hv}$) höheren Druck ($P_v$) voreingestellt und unter Aufrechterhaltung dieses größeren Druckes ($P_v$) durch Gasinjektion in die Hochvakuumkammer (1) eingestrahlt wird, in der das eingestrahlte Gas auf die Meßeinrichtung (5) trifft.

2. Verfahren nach Anspruch 1, **dadurch gekennzeichnet,** daß der größere Druck ($P_v$) auf einen Wert voreingestellt wird, der mindestens eine Größenordnung größer als der Hochvakuumdruck ($P_{hv}$) ist.

3. Verfahren nach Anspruch 2, **dadurch gekennzeichnet,** daß der größere Druck ($P_v$) auf einen Wert zwischen 10 und $10^5$ Pa voreingestellt wird.

4. Verfahren nach einem der vorhergehenden Ansprüche, **dadurch gekennzeichnet,**
   - daß die Meßeinrichtung (5) auf einen oder mehrere (n=1,2 ...) ausgewählte diskrete Strahldruckwerte ($p_{sti}$, i = 1, 2,..., n), auf die Atom- oder Molekularstrahlen (6; 7) der Molekularepitaxieeinrichtung einzustellen sind, eingemessen wird, indem für jeden diskreten Strahldruckwert ($p_{sti}$) das vorgebbare Gas genau auf einen zu diesem Strahldruckwert ($p_{sti}$) korrespondierenden diskreten Druckwert ($p_{vi}$) des höheren Druckes ($p_v$) voreingestellt, die Meßeinrichtung (5) mit dem auf diesen Druckwert ($p_{vi}$) eingestellten Gas beaufschlagt und der von der Meßeinrichtung (5) bei diesem Druckwert ($p_{vi}$) gelieferte Meßwert (m ($p_{vi}$)) als ursprünglicher Meßwert aufgenommen wird
   - daß zum Einstellen des Strahldruckes jedes gewünschten Atom- oder Molekularstrahls (6; 7) auf einen der diskreten Strahldruckwerte ($p_{sti}$) die Meßeinrichtung (5) mit diesem Strahl (6; 7) beaufschlagt und ein den Strahldruck dieses Strahls (6; 7) beeinflussender Betriebsparameter (P; T) einer diesen Strahl (6; 7) erzeugenden Quelle (60; 70) der Molekularstrahlepitaxieeinrichtung auf einen Parameterwert ($P_i$; $T_i$) eingestellt wird, bei dem die Meßeinrichtung (5) den bei dem zu diesem diskreten Strahldruckwert ($p_{sti}$) korrespondierenden diskreten Druckwert ($p_{vi}$) des höheren Druckes ($p_v$) aufgenommenen ursprünglichen Meßwert (m($p_{vi}$)) anzeigt,
   - daß die Meßeinrichtung (5) von Zeit zu Zeit für den oder die ausgewählten diskreten Strahldruckwerte ($p_{sti}$) nacheingemessen wird, indem bei jeder Nacheinmessung erneut für jeden diskreten Strahldruckwert ($p_{sti}$) die Meßeinrichtung (5) mit dem genau auf den zu diesem Strahldruckwert ($p_{sti}$) korrespondierenden diskreten Druckwert ($p_{vi}$) des höheren Druckes ($p_v$) eingestellten vorgebbaren Gas beaufschlagt und der von der Meßeinrichtung (5) bei diesem Druckwert ($p_{vi}$) gelieferte diskrete Meßwert ($m_j(p_{vi})$) neu aufgenommen wird,
   - daß danach die Meßeinrichtung (5) mit jedem gewünschten, auf einen zu einem der diskreten Druckwerte ($p_{vi}$) korrespondierenden Strahldruck ($p_{sti}$) einzustellenden Atom- oder Molekularstrahl (6; 7) beaufschlagt und der den Strahldruck dieses Strahls beeinflussende Betriebsparameter (P;T) der diesen Strahl erzeugenden Quelle (60; 70) der Molekularstrahlepitaxieeinrichtung auf einen Parameterwert ($P_{ji}$; $T_{ji}$) eingestellt wird, bei dem die Meßeinrichtung (5) den zu diesem diskreten Druckwert ($p_{vi}$) korrespondierenden neuen diskreten Meßwert ($m_j(p_{vi})$) anzeigt.

5. Verfahren nach Anspruch 4,
   **dadurch gekennzeichnet,**
   - daß bei einer Nacheinmessung des Meßgerätes (5) mit dem bei dieser Nacheinmessung für jeden diskreten Druckwert ($p_{vi}$) neu aufgenommenen diskreten Meßwert ($m_j(p_{vi})$) und dem dazu über diesen Druckwert ($p_{vi}$) korrespondierenden ursprünglichen diskreten Meßwert (m($p_{vi}$)) ein dieser Nacheinmessung zugeordneter Korrekturfaktor ($k_j(p_{vi})$, $k'_j(p_{vi})$) durch Bildung eines Quotienten ($m(p_{vi})/m_j(p_{vi})$; $m_j(p_{vi})/m(p_{vi})$) aus diesem ursprünglichen diskreten Meßwert (m($p_{vi}$)) und diesem neu aufgenommenen diskreten Meßwert ($m_j(p_{vi})$) errechnet wird,
   - und daß bei jeder auf diese Nacheinmessung folgenden Nacheinstellung des zu einem diskreten Druckwert ($p_{vi}$) korrespondierenden Strahldruckes ($p_{sti}$) eines die Meßeinrichtung (5) beaufschlagenden Atom- oder Molekularstrahls (6; 7) der Betriebsparameter (P; T) der diesen Strahl (6; 7) erzeu-

EP 0 458 077 B1

genden Quelle (60; 70) auf einen Parameterwert ($P_{ji}$; $T_{ji}$) eingestellt wird, bei dem das Meßgerät (5) einen Wert anzeigt, der gleich dem den zu diesem Druckwert ($p_{vi}$) korrespondierenden neuen Meßwert $m_j(p_{vi})$ ergebenden Quotienten ($m(p_{vi})/k_j(p_{vi})$) oder Produkt ($m(p_{vi})/k'_j(p_{vi})$) aus dem zu diesem diskreten Druckwert ($p_{vi}$) korrespondierenden ursprünglichen Meßwert ($m(p_{vi})$) und dem zu diesem Druckwert ($p_{vi}$) korrespondierenden Korrekturfaktor ($k_j(p_{vi})$; $k'_j(p_{vi})$) ist.

6. Verfahren nach einem der vorhergehenden Ansprüche,
**dadurch gekennzeichnet,**
- daß bei vorgebbaren diskreten Druckwerten ($p_{vi}$) des höheren Druckes ($p_v$) ursprüngliche diskrete Meßwerte ($m(p_{vi})$) aufgenommen werden,
- daß durch ein vorgebbares Interpolations- und/oder Extrapolationsverfahren eine in einem vorbestimmten kontinuierlichen Druckwertbereich ($\Delta p_v$) des höheren Druckes ($p_v$) kontinuierlich von diesem Druck ($p_v$) abhängige ursprüngliche Meßwertfunktion ($M(p_v)$) erstellt wird,
- daß zum Einstellen des kontinuierlich vom höheren Druck ($p_v$) des vorgebbaren Gases abhängigen Strahldruckes ($p_{st}$) jedes gewünschten Atom- oder Molekularstrahls (6; 7) auf einen zu einem vorbestimmten Druckwert ($P_{vx}$) aus dem Druckwertbereich ($\Delta p_v$) des höheren Druckes ($p_v$) korrespondierenden Strahldruckwert ($p_{stx}$) die Meßeinrichtung (5) mit diesem Strahl (6; 7) beaufschlagt und der den Strahldruck dieses Strahls (6; 7) beeinflussende Betriebsparammeter (P; T) der diesen Strahl (6; 7) erzeugenden Quelle (60; 70) der Molekularstrahlepitaxieeinrichtung auf einen Parameterwert ($P_x$; $T_x$) eingestellt wird, bei dem die Meßeinrichtung (5) den zu diesem Druckwert ($p_{vx}$) gehörigen Funktionswert ($m(p_{vx})$) der Meßwertfunktion ($M(p_v)$) anzeigt,
- daß aus den bei einer Nacheinmessung der Meßeinrichtung (5) neu aufgenommen diskreten Meßwerten ($m_j(p_{vi})$) durch ein vorgebbares Interpolations- und/oder Extrapolationsverfahren eine in dem vorbestimmten Druckwertbereich ($\Delta p_v$) des höheren Druckes ($p_v$) kontinuierlich von diesem Druck ($p_v$) abhängige neue Meßwertfunktion ($M_j(p_v)$) explizite oder implizite erstellt wird,
- daß danach die Meßeinrichtung (5) mit jedem gewünschten Atom- oder Molekularstrahl (6; 7), dessen Strahldruck ($p_{st}$) auf einen zu einem Druckwert ($p_{vx}$) aus dem vorbestimmten Druckwertbereich ($\Delta p_v$) korrespondierenden Strahldruckwert ($p_{stx}$) einzustellen ist, beaufschlagt und der den Strahldruck dieses Strahls (6; 7) beeinflussende Betriebsparameter (P; T) der diesen Strahl (6; 7) erzeugenden Quelle (60; 70) der Molekularstrahlepitaxieeinrichtung auf einen Parameterwert ($P_{jx}$; $T_{jx}$) eingestellt wird, bei dem die Meßeinrichtung (5) den zu diesem Druckwert ($p_{vx}$) gehörenden Funktionswert ($m_j(p_{vx})$) der neuen Meßwertfunktion ($M_j(p_v)$) anzeigt.

7. Verfahren nach Anspruch 6,
**dadurch gekennzeichnet,**
daß bei der Nacheinmessung des Meßgerätes (5) eine Korrekturfaktorfunktion ($K(p_v)$) erstellt wird, bei der jedem Druckwert ($p_{vx}$) aus dem Druckwertbereich ($\Delta p_v$) ein Korrekturfunktionswert ($k_j(p_{vx})$; $k'_j(p_{vx})$) zugeordnet ist, der einem Quotienten ($m(p_{vx})/m_j(p_{vx})$; $m_j(p_{vx})/m(p_{vx})$) aus dem zu diesem Druckwert ($p_{vx}$) gehörenden Funktionswert ($m(p_{vx})$) der ursprünglichen Meßwertfunktion ($M(p_v)$) und dem zu diesem Druckwert ($p_{vx}$) gehörenden Funktionswert ($m_j(p_{vx})$) der neuen Meßwertfunktion ($M_j(p_v)$) entspricht, und
- daß bei einer auf diese Nacheinmessung folgenden Nacheinstellung des Strahldrucks eines die Meßeinrichtung (5) beaufschlagenden Atom- oder Molekularstrahls (6; 7) auf einen zu einem Druckwert ($p_{vx}$) aus dem Druckwertbereich ($\Delta p_v$) korrespondierenden Strahldruckwert ($p_{stx}$) der Betriebsparameter (P; T) der diesen Strahl (6; 7) erzeugenden Quelle (60; 70) auf einen Parameterwert ($P_{jx}$; $T_{jx}$) eingestellt wird, bei dem die Meßeinrichtung (5) einen Wert anzeigt, der gleich dem den zu diesem Druckwert ($p_{vx}$) gehörenden Funktionswert ($m_j(p_{vx})$) der neuen Meßwertfunktion ($M_j(p_v)$) ergebenden Quotienten ($m(p_{vx})/k_j(p_{vx})$) oder Produkt ($m(p_{vx}).k'_j(p_{vx})$) aus dem zu diesem Druckwert ($p_{vx}$) gehörenden ursprünglichen Meßwert $m(p_{vx})$ und dem zu diesem Druckwert ($p_{vx}$) gehörenden Korrekturfunktionswert ($k_j(p_{vx})$; $k'_j(p_{vx})$) der Korrekturfaktorfunktion ($K(p_v)$; $K^{-1}(p_v)$).

8. Eichvorrichtung für eine Molekularstrahlepitaxieeinrichtung mit einer Hochvakuumkammer (1) und einer in der Hochvakuumkammer (1) angeordneten Meßeinrichtung (5) zum Messen des Strahldrucks ($P_{st}$), eines in die evakuierte Hochvakuumkammer (1) eingestrahlten kristallkonstituierenden Atom- oder Molekularstrahls, insbesondere einer Festquellen-Molekularstrahlepitaxieeinrichtung, zur Durchführung eines Verfahrens zum Eichen oder Nacheichen der Meßeinrichtung (5) nach einem der vorhergehenden Ansprüche,
**gekennzeichnet durch**
eine das Innere der Hochvakuumkammer (1) mit einer Gasquelle (21) verbindende Gasleitung (20), in der ein Regelventil (22) angeordnet und an die Präzisionsdruckaufnehmer (24) als Istwertgeber für das Regelventil (22) angeschlossen ist.

## Claims

1. Method of calibrating or recalibrating a measuring device (5) for measuring the flux pressure ($P_{st}$) of a crystal-building atomic or molecular beam (6; 7) radiated into the evacuated high-vacuum chamber (1), which measuring device (5) is disposed in a high-vacuum chamber (1) of a molecular-beam epitaxial device, in particular a solid-source molecular-beam epitaxial device, characterized in that, to calibrate or recalibrate the measuring device (5), a specifiable gas is preset precisely to a predetermined pressure ($P_v$) which is higher than the high-vacuum pressure ($P_{hv}$) prevailing in the evacuated high-vacuum chamber (1) and is radiated by gas injection into the high-vacuum chamber (1), in which the gas radiated-in strikes the measuring device (5), while maintaining said higher pressure ($P_v$).

2. Method according to Claim 1, characterized in that the higher pressure ($P_v$) is preset to a value which is at least an order of magnitude greater than the high-vacuum pressure ($P_{hv}$).

3. Method according to Claim 2, characterized in that the higher pressure ($P_v$) is preset to a value between 10 and $10^5$ Pa.

4. Method according to one of the preceding claims, characterized
   - in that the measuring device (5) is calibrated for one or more (n = 1,2...) selected discrete flux pressure values ($p_{sti}$, i = 1, 2,..., n) to which the atomic or molecular beams (6; 7) of the molecular-epitaxy device can be set by presetting, for each discrete flux pressure value ($p_{sti}$), the specifiable gas precisely to a pressure value ($p_{vi}$) of the higher pressure ($p_v$), which discrete pressure value ($p_{vi}$) corresponds to said flux pressure value ($p_{sti}$), exposing the measuring device (5) to the gas set to said pressure value ($p_{vi}$) and recording the measured value (m)($p_{vi}$)) provided by the measuring device (5) at said pressure value ($p_{vi}$) as original measured value,
   - in that, to set the flux pressure of every desired atomic or molecular beam (6; 7) to one of the discrete flux pressure values ($p_{sti}$), the measuring device (5) is exposed to said beam (6; 7) and an operating parameter (P; T), which influences the flux pressure of said beam (6; 7), of a source (60; 70) of the molecular-beam epitaxial device, which source (60; 70) generates said beam (6; 7) is set to a parameter value ($P_i$; $T_i$) at which the measuring device (5) indicates the original measured value ($m(p_{vi})$) recorded at that discrete pressure value ($p_{vi}$) of the higher pressure ($p_v$) that corresponds to said discrete flux pressure value ($p_{sti}$),
   - in that the measuring device (5) is recalibrated from time to time for the selected discrete flux pressure value or values ($p_{sti}$) by exposing, for every discrete flux pressure value ($p_{sti}$), the measuring device (5) during each recalibration to the specifiable gas set precisely to the discrete pressure value ($p_{vi}$) of the higher pressure ($p_v$) that corresponds to said flux pressure value ($p_{sti}$) and the discrete measured value ($m_j(p_{vi})$) provided by the measuring device (5) at said pressure value ($p_{vi}$) is re-recorded, and
   - in that the measuring device (5) is then exposed to any desired atomic or molecular beam (6; 7) to be set to a flux pressure ($p_{sti}$) corresponding to one of the discrete pressure values ($p_{vi}$) and the operating parameter (P; T), which influences the flux pressure of said beam, of the source (60; 70), which generates said beam, of the molecular-beam epitaxial device is set to a parameter value ($P_{ji}$; $T_{ji}$) at which the measuring device (5) indicates the new discrete measured value ($m_j(p_{vi})$) corresponding to said discrete pressure value ($p_{vi}$).

5. Method according to Claim 4, characterized
   - in that, during a recalibration of the measuring device (5) with the discrete measured value ($m_j(p_{vi})$) re-recorded during said recalibration for every discrete pressure value ($p_{vi}$) and the original discrete measured value ($m(p_{vi})$) corresponding thereto via said pressure value ($p_{vi}$), a correction factor ($kj(p_{vi})$, $k'_j(p_{vi})$) assigned to said recalibration is calculated from said original discrete measured value ($m(p_{vi})$) and said re-recorded discrete measured value ($m_j(p_{vi})$) by forming a quotient ($m(p_{vi})/m_j(p_{vi})$; $m_j(p_{vi})/m(p_{vi})$),
   - and in that, during every resetting, subsequent to said recalibration, of the flux pressure ($p_{sti}$), corresponding to a discrete pressure value ($p_{vi}$) of an atomic or molecular beam (6; 7) to which the measuring device (5) is exposed, the operating parameter (P; T) of the source (60; 70), generating said beam (6; 7) is set to a parameter value ($P_{ji}$; ($T_{ji}$) at which the measuring device (5) indicates a value which is equal to the quotient ($m(p_{vi})/k_j(p_{vi})$) or product ($m(p_{vi})/k'_j(p_{vi})$), yielding the new measured value $m_j(p_{vi})$ corresponding to said pressure value ($p_{vi}$), of the original measured value ($m(p_{vi})$) corresponding to said discrete pressure value ($p_{vi}$) and the correction factor ($k_j(p_{vi})$; $k'_j(p_{vi})$) corresponding to said pressure value ($p_{vi}$).

6. Method according to one of the preceding claims, characterized
   - in that, at specifiable discrete pressure values ($p_{vi}$) of the higher pressure ($p_v$), original discrete measured values ($m(p_{vi})$) are recorded,
   - in that, as a result of a specifiable interpolation and/or extrapolation method, an original measured value function ($M(p_v)$) is derived which is continuously dependent on said pressure ($p_v$) in a predetermined, continuous pressure-value range ($\Delta p_v$) of the higher pressure ($p_v$),
   - in that, to set that flux pressure ($p_{st}$) of any desired atomic or molecular beam (6; 7) that is continuously dependent on the higher pressure ($p_v$) of the specifiable gas to a flux pressure value ($p_{stx}$) corresponding to a predetermined pressure value ($p_{vx}$) from the pressure-value range ($\Delta p_v$) of the higher pressure ($p_v$), the measuring device (5) is exposed to said beam (6; 7) and the operating parameter (P; T), influencing the flux pressure of said beam (6; 7), of the source (60; 70), generating said beam (6; 7), of the molecular-beam epitaxial device is set to a parameter value ($P_x$; $T_x$) at which the measuring device (5) indicates that function value ($m(p_{vx})$) of the measured value function ($M(p_v)$) that is associated with said pressure value ($p_{vx}$),
   - in that a new measured-value function ($M_j(p_v)$) which is dependent in the predetermined pressure-value range ($\Delta p_v$) of the higher pressure ($p_v$), continuously on said pressure ($p_v$) is explicitly or implicitly derived from the discrete measured values ($m_j(p_{vi})$) re-recorded during recalibration of the measuring device (5) by a specifiable interpolation and/or extrapolation method,
   - and in that the measuring device (5) is then exposed to any desired atomic or molecular beam (6; 7) whose flux pressure ($p_{st}$) can be set to a flux pressure value ($p_{stx}$) corresponding to a pressure value ($p_{vx}$) from the predetermined pressure-value range ($\Delta p_v$) and the operating parameter (P; T), influencing the flux pressure of said beam (6; 7), of the source (60; 70), generating said beam (6; 7), of the molecular-beam epitaxial device is set to a parameter value ($P_{jx}$; $T_{jx}$) at which the measuring device (5) indicates that function value ($m_j(p_{vx})$) of the new measured-value function ($M_j(p_v)$) that is associated with said pressure value ($p_{vx}$).

7. Method according to Claim 6, characterized
   - in that, during the recalibration of the measuring device (5), a correction-factor function ($K(p_v)$) is derived for which there is assigned to every pressure value ($p_{vx}$) from the pressure-value range ($\Delta p_v$), a correction-function value ($k_j$ ($p_{vx}$); $k'j(p_{vx})$) which corresponds to a quotient ($m(p_{vx})/m_j(p_{vx})$; $m_j(p_{vx})/m(p_{vx})$) of that function value ($m(p_{vx})$) of the original measured-value function ($M(p_v)$) that is associated with said pressure value ($p_{vx}$) and that function value ($m_j(p_{vx})$) of the new measured value function ($M_j(p_v)$) that is associated with said pressure value ($p_{vx}$), and
   - in that, during a resetting, subsequent to said recalibration, of the flux pressure of an atomic or molecular beam (6; 7) to which the measuring device (5) is exposed to a flux pressure value ($p_{stx}$) corresponding to a pressure value ($p_{vx}$) from the pressure-value range ($\Delta p_v$), the operating parameter (P; T) of the source (60; 70) generating said beam (6; 7) is set to a parameter value ($P_{jx}$; $T_{jx}$) at which the measuring device (5) indicates a value which is equal to the quotient ($m(p_{vx})/k_j(p_{vx})$) or product ($m(p_{vx}).k'_j(p_{vx})$), yielding the function value ($m_j(p_{vx})$) of the new measured-value function $M_j(p_v)$) that is associated with said pressure value ($p_{vx}$), of the original measured value $m(p_{vx})$ associated with said pressure value ($p_{vx}$) and that correction-function value ($k_j(p_{vx})$; $k'_j(p_{vx})$) of the correction-factor function ($K(p_v)$; $K^{-1}(p_v)$) that is associated with said pressure value ($p_{vx}$).

8. Calibration device for a molecular-beam epitaxial device comprising a high-vacuum chamber (1) and a measuring device (5) disposed in the high-vacuum chamber (1), for measuring the flux pressure ($P_{st}$) of a crystal-building atomic or molecular beam radiated into the evacuated high-vacuum chamber (1), in particular a solid-source molecular-beam epitaxial device, for carrying out a method of calibrating or recalibrating the measuring device (5) according to one of the preceding claims, characterized by a gas pipe (20) which connects the interior of the high-vacuum chamber (1) to a gas source (21), in which a control valve (22) is disposed and to which precision pressure sensor (24) is connected as actual-value sensor for the control valve (22).

EP 0 458 077 B1

**Revendications**

1. Procédé pour étalonner ou réétalonner un appareil de mesure (5), qui est disposé dans une chambre à vide poussé (1) d'un dispositif d'épitaxie à faisceau moléculaire, notamment d'un dispositif d'épitaxie à faisceau moléculaire à source fixe, pour la mesure de la pression ($P_{st}$) du faisceau atomique ou moléculaire (6; 7) introduit dans la chambre à vide poussé vidé (1), et servant à former un cristal, caractérisé par le fait que pour l'étalonnage ou le réétalonnage de l'appareil de mesure (5), un gaz pouvant être prédéterminé est préréglé de façon précise à une pression prédéterminée ($P_v$) qui est accrue par rapport à la pression de vide poussé ($P_{hv}$), qui règne dans la chambre à vide poussé vidée (1), et est introduit, moyennant le maintien de cette pression accrue ($P_v$), au moyen d'une injection de gaz, dans la chambre à vide poussé (1), dans laquelle le gaz introduit rencontre l'appareil de mesure (5).

2. Procédé suivant la revendication 1, caractérisé par le fait que la pression accrue ($P_v$) est préréglée à une valeur qui est supérieure, d'au moins un ordre de grandeur, à la pression de vide poussé ($P_{sv}$).

3. Procédé selon la revendication 2, caractérisé en ce que la pression accrue ($P_v$) est préréglée à une valeur comprise entre 10 et $10^5$ Pa.

4. Procédé suivant l'une des revendications précédentes, caractérisé par le fait
   - que l'appareil de mesure (5) est étalonné sur une ou plusieurs (n = 1,2...) valeurs de pression discrètes sélectionnées du faisceau ($P_{sti}$, i = 1, 2, ..., n), sur lesquelles des faisceaux atomiques ou moléculaires (6; 7) du dispositif d'épitaxie moléculaire doivent être réglés, par le fait que pour chaque valeur de pression discrète du faisceau ($p_{sti}$), le gaz pouvant être prédéterminé est préréglé de façon précise sur une valeur discrète ($p_{vi}$), qui correspond à cette valeur de pression ($p_{sti}$), de la pression accrue ($p_v$), charge l'appareil de mesure (5) avec le gaz réglé à cette valeur de pression ($p_{vi}$) et que la valeur de mesure ($m(p_{vi})$), délivrée par l'appareil de mesure (5) pour cette valeur de pression ($p_{vi}$), est enregistrée en tant que valeur initiale,
   - que pour le réglage de la pression de chaque faisceau atomique ou moléculaire désiré (6; 7) sur l'une des valeurs discrètes de la pression ($p_{sti}$), l'appareil de mesure (5) est chargé avec ce faisceau (6; 7) et qu'un paramètre de service (P; T), qui influe sur la pression de ce faisceau (6; 7), d'une source (60; 70), qui produit ce faisceau (6; 7), du dispositif d'épitaxie à faisceau moléculaire, est réglé à une valeur ($P_i$; $T_i$), pour laquelle l'appareil de mesure (5) indique la valeur de mesure initiale ($m(p_{vi})$) enregistrée pour la valeur discrète ($p_{vi}$) de la pression accrue ($p_v$), qui correspond à cette valeur discrète ($p_{sti}$) de la pression du faisceau,
   - que l'appareil de mesure (5) est réétalonné de temps à autres pour la ou les valeurs discrètes sélectionnées ($p_{sti}$) de la pression du faisceau, par le fait que lors de chaque réétalonnage, l'appareil de mesure (5) est chargé, à nouveau pour chaque valeur discrète ($p_{sti}$) de la pression du faisceau, par le gaz pouvant être prédéterminé, qui est réglé précisément à la valeur discrète ($p_{vi}$) de la pression accrue ($p_v$), qui correspond à cette valeur ($p_{sti}$) de la pression du faisceau, et la valeur discrete de mesure ($m_j$ ($p_i$)), qui est délivrée par l'appareil de mesure (5) pour cette valeur de pression ($p_{vi}$), est à nouveau enregistrée,
   - qu'ensuite l'appareil de mesure (5) est chargé par chaque faisceau atomique ou moléculaire désiré (6; 7), qui doit être réglé sur une pression ($p_{sti}$) du faisceau, qui correspond à l'une des valeurs discrètes de pression ($p_{vi}$), et le paramètre de service (P; T), qui influe sur la pression de ce faisceau, de la source (60; 70), qui produit ce faisceau, du dispositif d'épitaxie à faisceau moléculaire est réglé à une valeur ($P_{ji}$; $T_{ji}$), pour laquelle l'appareil de mesure (5) indique la nouvelle valeur de mesure discrète ($m_j(p_{vi})$), qui correspond à cette valeur discrète de pression ($P_{vi}$).

5. Procédé suivant la revendication 4, caractérisé en ce
   - que lors d'un réétalonnage de l'appareil de mesure (5), avec la valeur de mesure discrete ($m_j(p_{vi})$), qui est à nouveau enregistrée lors de ce réétalonnage pour chaque valeur de pression discrète ($p_{vi}$), et avec la valeur de mesure discrète initiale ($m(p_{vi})$) qui correspond à cette valeur de pression ($p_i$), un facteur de correction ($k_j(p_{vi})$, $k'_j(p_{vi})$), associé à ce réétalonnage, est calculé par formation d'un quotient ($m(p_{vi})/m_j(p_{vi})$; $m_j(p_{vi})/m(p_{vi})$) à partir de cette valeur de mesure discrète initiale ($m(p_{vi})$) et de cette valeur discrète ($m_j(p_{vi})$) enregistrée à nouveau, et
   - que, lors de chaque réglage ultérieur, qui succède à ce réétalonnage, de la pression ($p_{sti}$) qui correspond à une valeur discrète de pression ($p_{vi}$) d'un faisceau atomique ou moléculaire (6; 7) qui charge l'appareil de mesure (5), le paramètre de service (P; T) de la source (60, 70) qui produit ce faisceau (6; 7), est réglé à une valeur ($P_{ji}$; $T_{ji}$), pour laquelle l'appareil de mesure (5) indique une valeur, qui est égale au quotient ($m(p_{vi})/k_j(p_{vi})$) ou au produit ($m(p_{vi})/k'_j(p_{vi})$), qui fournit la nouvelle vleur de mesure ($m_j(p_{vi})$) qui correspond à cette valeur de pression ($p_{vi}$), entre la valeur de mesure initiale ($m(p_{vi})$), qui correspond à cette valeur de pression initiale ($p_{vi}$), et le facteur de correction ($k_j(p_{vi})$; $k'_j(p_{vi})$), qui correspond à cette valeur de correction ($p_{vi}$).

6. Procédé suivant l'une des revendications précédentes, caractérisé par le fait

- que, pour des valeurs discrètes ($p_{vi}$), pouvant être prédéterminées, de la pression accrue ($p_v$), des valeurs initiales discrètes de mesure ($m(p_{vi})$) sont enregistrées,
- qu'au moyen d'un procédé d'interpolation et/ou d'extrapolation pouvant être prédéterminé, est établie une fonction initiale de valeur de mesure ($M(p_v)$), qui dépend continûment de la pression ($p_v$), dans une gamme continue prédéterminée ($\Delta p_v$) de valeurs de la pression accrue ($p_v$),
- que pour le réglage de la pression ($p_{st}$), qui dépend continûment de la pression accrue ($p_v$) du gaz pouvant être prédéterminé, de chaque faisceau atomique ou moléculaire désiré (6; 7) sur une valeur ($p_{stx}$) de la pression du faisceau, qui correspond à la gamme ($\Delta p_v$) de valeurs de la pression accrue ($p_v$), l'appareil de mesure (5) est chargé par ce faisceau (6; 7), et le paramètre de service (P; T), qui influe sur la pression de ce faisceau (6; 7), de la source (60; 70), qui produit ce faisceau (6; 7), du dispositif d'épitaxie à faisceau moléculaire est réglé sur une valeur ($P_x$; $T_x$), pour laquelle l'appareil de mesure (5) indique la valeur ($m(p_{vx})$), qui est associée à cette valeur de pression ($p_{vx}$), de la fonction de valeur de mesure ($M(p_v)$),
- qu'à partir des valeurs de mesure discrètes ($m_j(p_{vi})$), enregistrées à nouveau lors d'un reétalonnage de l'appareil de mesure (5), est établie, de façon explicite ou implicite, au moyen d'un procédé d'interpolation et/ou d'extrapolation pouvant être prédéterminé, une nouvelle fonction de valeur de mesure ($M_j (p_v)$, qui dépend continûment de la pression accrue ($p_v$), dans la gamme prédéterminée ($\Delta p_v$) de valeurs de cette pression accrue,
- qu'ensuite l'appareil de mesure (5) est chargé par chaque faisceau moléculaire désiré (6; 7), dont la pression ($p_{stl}$) doit être réglée sur une valeur ($p_{stx}$), qui correspond a la gamme prédéterminée ($\Delta p_v$) des valeurs de pression, et que le paramètre de service (P; T), qui influe sur la pression de ce faisceau (6; 7), de la source (60; 70), qui produit ce faisceau (6; 7), du dispositif d'épitaxie à faisceau moléculaire, est réglé sur une valeur ($P_{jx}$;; $T_{jx}$) pour laquelle l'appareil de mesure (5) indique la valeur ($m_j(p_{vx})$) qui est associée à cette valeur de pression ($p_{vx}$), de la nouvelle fonction de valeur de mesure ($M_j(p_v)$).

7. Procédé selon la revendication 6, caractérisé en ce que, lors du réétalonnage de l'appareil de mesure (5), une fonction de facteur de correction ($K(p_v)$) est établie, pour laquelle à chaque valeur de pression ($p_{vx}$) appartenant à la gamme ($\Delta p_v$) des valeurs de pression est associée une valeur de fonction de correction ($k_j(p_{vx})$ ; $k'_j(p_{vx})$), qui correspond à un quotient ($m(p_{vx}) /m_j(p_{vx})$; $m_j (p_{vx}) /m(p_{vx})$) entre la valeur de fonction ($m(p_{vx})$), qui est associée à cette valeur de pression ($p_{vx}$), de la fonction de valeur de mesure initiale ($M(p_v)$) et la valeur ($m_j(p_{vx})$), qui est associée à cette valeur de pression ($p_{vx}$), de la nouvelle fonction de valeur de mesure ($M_j(p_v)$), et

- que dans le cas d'un réglage ultérieur, qui succède à ce réétalonnage, de la pression d'un faisceau atomique ou moléculaire (6; 7), qui charge l'appareil de mesure (5), à une valeur de ($p_{stx}$) de la pression du faisceau, qui correspond à une valeur de pression ($p_{vx}$) appartenant à la gamme ($\Delta p_v$) des valeurs de pression, le paramètre de service (P; T) de la source (60; 70), qui produit ce faisceau (6; 7) est réglé à une valeur ($P_{jx}$; $T_{jx}$), pour laquelle l'appareil de mesure (5) indique une valeur, qui est égale au quotient ($m(p_{vx})/k_j(p_{vx})$) ou au produit ($m(p_{vx}).k'_j(p_{vx})$, qui fournit la valeur ($m_j(p_{vx})$), associée à cette valeur de pression ($p_{vx}$), de la nouvelle fonction de valeur de mesure ($M_j(p_v)$), entre la valeur de mesure initiale ($m(p_{vx})$, qui appartient à cette valeur de pression ($p_{vx}$), et la valeur ($k_j(p_{vx})$; $k'_j(p_{vx})$), qui est associée à cette valeur de pression ($p_{vx}$), de la fonction de facteur de correction ($K(p_v)$; $K^{-1}(p_v)$).

8. Dispositif d'étalonnage pour un dispositif d'épitaxie à faisceau moléculaire comportant une chambre à vide poussé (1) et un appareil de mesure (5) disposé dans la chambre à vide poussé (1) et servant à mesurer la pression ($P_{st}$) d'un faisceau atomique ou moléculaire, qui est inséré dans la chambre à vide poussé vidée (1) et forme un cristal, notamment un dispositif d'épitaxie à faisceau moléculaire à source fixe, pour la mise en oeuvre d'un procédé d'étalonnage ou de réétalonnage de l'appareil de mesure (5) suivant l'une des revendications précédentes, caractérisé par une canalisation (20) pour le gaz, qui raccorde l'intérieur de la chambre à vide poussé (1) à une source de gaz (21) et dans laquelle est montée une soupape de régulation (22), qui est raccordée à l'enregistreur de pression de précision (24) en tant que capteur de valeur réelle pour la soupape de régulation (22).

FIG 1

FIG 2

$p_{sti} \approx f(p_{vi})$

$p_{stx} \approx f(p_{vx})$